Europäisches Patentamt

European Patent Office

Office européen des brevets

(19)

(11) EP 0 561 677 B1

(12) FASCICULE DE BREVET EUROPEEN

(45) Date de publication et mention
de la délivrance du brevet:
**19.06.1996 Bulletin 1996/25**

(51) Int Cl.⁶: **H03H 9/08**, H03H 9/05

(21) Numéro de dépôt: **93400638.8**

(22) Date de dépôt: **12.03.1993**

(54) **Résonateur pour oscillateur thermostaté à faible consommation et chauffage rapide**

Resonatur für einen temperaturkompensierten Oszillator mit geringem Energieverbrauch und schneller Aufwärmzeit

Resonator for thermostatically regulated oscillator having low power consumption and rapid warm up

(84) Etats contractants désignés:
**CH DE FR GB LI NL**

(30) Priorité: **17.03.1992 FR 9203175**

(43) Date de publication de la demande:
**22.09.1993 Bulletin 1993/38**

(73) Titulaire: **ECOLE NATIONALE SUPERIEURE DE MECANIQUE ET DES MICROTECHNIQUES F-25030 Besançon Cédex (FR)**

(72) Inventeurs:
• **Besson, Raymond J.**
**F-25000 Besancon (FR)**
• **Galliou, Serge J.**
**F-25170 Audeux (FR)**
• **Mourey, Marc H.**
**F-25000 Besancon (FR)**

(74) Mandataire: **Thévenet, Jean-Bruno et al Cabinet Beau de Loménie 158, rue de l'Université 75340 Paris Cédex 07 (FR)**

(56) Documents cités:
**EP-A- 0 023 171**

• **PATENT ABSTRACTS OF JAPAN vol. 15, no. 130 (E-1051)29 Mars 1991 & JP-A-30 14 303**

**EP 0 561 677 B1**

**Description**

La présente invention qui est due au travaux de Messieurs R.BESSON, S. GALLIOU et M. MOUREY du laboratoire de chronométrie, électronique et piézoélectricité de l'Ecole Nationale Supérieure de Mécanique et des Microtechniques de l'Université de Franche-Comté-Besançon, France, concerne les résonateurs piézo-électriques et plus particulièrement un résonateur pour oscillateur thermostaté à faible consommation et chauffage rapide utilisable dans de nombreux domaines d'activités notamment l'avionique, les télécommunications ou bien encore les radars.

On connait divers exemples de résonateurs piézo-électriques.

Selon un premier exemple classique, un cristal résonateur est constitué par une plaquette de quartz bi-plan, plan-convexe ou bi-convexe à contour circulaire, sur les faces frontales de laquelle sont déposées directement des électrodes métalliques, dites électrodes adhérentes.

Selon un autre exemple de réalisation, la plaquette de quartz à électrodes adhérentes est limitée extérieurement par une couronne en quartz servant au support du cristal-résonateur.

Selon encore un autre exemple de réalisation, le cristal-résonateur est relié à une couronne en quartz par des ponts taillés dans la masse. Les électrodes peuvent être adhérentes ou non adhérentes. Dans ce dernier cas, les électrodes sont déposées sur des plaquettes de quartz de même coupe que le cristal et de forme similaire et seules les couronnes des plaquettes-support d'électrodes sont en contact avec la couronne du cristal vibrant (voir par exemple la demande EP-A-0 023 171).

Cette disposition, dans laquelle le cristal est autosuspendu, en supprimant toutes diffusion métallique, thermocompressions ou fixations quelconques au niveau de la partie active du cristal, permet l'obtention d'une excellente stabilité en fréquence ainsi qu'une meilleure résistance aux chocs.

Toutefois, cette stabilité en fréquence nécessite un parfait contrôle de la température dont les moindres fluctuations se répercutent sur la fréquence d'oscillation du cristal du résonateur. C'est pourquoi, de manière habituelle, le résonateur est placé dans un thermostat de très haute précision destiné à limiter ces fluctuations mais dont malheureusement le fonctionnement nécessite un besoin d'énergie non négligeable.

Ainsi actuellement, il n'existe pas d'oscillateur thermostaté dont la consommation soit inférieure à 100 mW et qui puisse, en outre, permettre de façon sûre une mise en fréquence à $10^{-9}$ qui serait effectuée en moins de 4 minutes.

Or, le besoin d'un tel oscillateur est patent dans les domaines cités en tête de la description.

La présente invention concerne donc un résonateur piézo-électrique, en particulier pour oscillateur thermostaté à faible consommation et chauffage rapide, du type comprenant, montés dans un boîtier étanche, au moins un cristal piézo-électrique interposé entre des première et seconde électrodes reliées respectivement à des premier et second conducteurs se prolongeant hors du boîtier, et un moyen de fixation du cristal piézo-électrique à l'intérieur du boîtier, le cristal piézo-électrique comprenant une partie centrale et une partie périphérique formant un anneau entourant à distance la partie centrale et reliée à celle-ci par une partie intermédiaire, présentant une faible longueur dans le sens radial, et dans laquelle est pratiquée une lumière, caractérisé en ce que la partie périphérique est reliée à la partie centrale par un unique pont de liaison constitué par la partie non évidée de cette partie intermédiaire, qui s'étend sur une faible fraction de la périphérie de cette partie intermédiaire et en ce que la partie centrale constitue la partie vibrante active du cristal tandis que la partie périphérique est immobilisée dans le boîtier par le moyen de fixation disposé de telle sorte qu'il soit thermiquement le plus éloigné possible de l'unique pont de liaison, ladite partie immobilisée et ledit pont constituant des moyens de suspension du cristal.

Cette réalisation à un unique pont de liaison est remarquable en ce qu'elle assure une canalisation des flux thermiques de conduction et permet donc un contrôle considérablement amélioré de la température du résonateur.

Le résonateur comprend un élément chauffant placé au plus prés de la partie centrale vibrante, au niveau de la partie périphérique prolongeant l'unique pont de liaison, et un capteur de température disposé à côté de cet élément chauffant, et des moyens sont prévus pour réguler la puissance électrique de l'élément chauffant en fonction de la température mesurée par le capteur de température afin d'assurer une température constante pour le cristal piézo-électrique.

Dans un premier mode de réalisation, la partie périphérique formant anneau est interrompue créant une ouverture dont l'une des parois est disposée dans le prolongement de l'un des bords latéraux du pont unique de liaison, l'autre paroi délimitant une extrémité libre à laquelle est fixé le moyen de fixation de telle sorte que celui-ci soit thermiquement le plus éloigné possible du pont unique de liaison recevant l'élément chauffant et le capteur de température.

Selon une caractéristique particulière, la partie périphérique formant anneau peut varier continûment d'une largeur minimale au niveau du pont de liaison à une largeur maximale au niveau de son extrémité libre où se trouve placé l'élément de fixation, la largeur de la partie intermédiaire restant constante.

Dans un second mode de réalisation, le moyen de fixation du cristal au boîtier est placé au niveau d'une zone de la partie périphérique située à l'opposé du pont unique de liaison par rapport à la partie centrale active, et des restrictions thermiques sont pratiquées symétriquement dans cette partie périphérique, de part et d'autre de la partie centrale, de telle sorte que le moyen de fixation soit thermiquement le plus éloigné possible de l'élément chauffant et du capteur de température.

Préférentiellement, les restrictions thermiques sont réalisées dans une direction perpendiculaire à la direction radiale définie par l'axe de symétrie du pont unique de liaison.

Selon une caractéristique particulière, la partie périphérique formant anneau peut présenter au moins deux largeurs distinctes, une première largeur pour une première partie de cet anneau comprise entre le pont unique de liaison et les restrictions thermiques et une seconde largeur pour une seconde partie comprise entre ces restrictions thermiques et le moyen de fixation, la largeur de la partie intermédiaire restant constante.

D'autres caractéristiques et avantages de la présente invention ressortiront mieux à la lecture de la description qui va suivre faite en référence aux dessins annexés sur lesquels :

- la figure 1 montre une vue de dessus d'un résonateur selon l'invention dans lequel la couronne extérieure est interrompue,
- la figure 1a est une coupe selon la ligne Ia-Ia de la figure 1 montrant la mise en oeuvre d'un écran réflecteur,
- la figure 2 montre une autre configuration d'un résonateur selon l'invention présentant une couronne extérieure complète,
- la figure 3 est une configuration analogue à celle de la figure 2 dans laquelle la couronne extérieure présente une largeur viable dans le sens radial,
- la figure 4 est une configuration analogue à celle de la figure 1 dans laquelle la couronne extérieure présente une largeur viable dans le sens radial,
- les figures 5 et 6 représentent, selon deux variantes de réalisation, dans une configuration à électrodes adhérentes, des exemples de montages d'un résonateur, tel que celui de la figure 1, en coupe dans le plan V,VI,VII,VIII-V,VI, VII,VIII passant par le support du résonateur, et
- les figures 7 et 8 représentent selon deux variantes de réalisation, dans une configuration à électrodes non adhérentes, des exemples de montages d'un résonateur, tel que celui de la figure 1, en coupe dans le plan V,VI,VII, VIII-V,VI,VII,VIII passant par le support du résonateur.

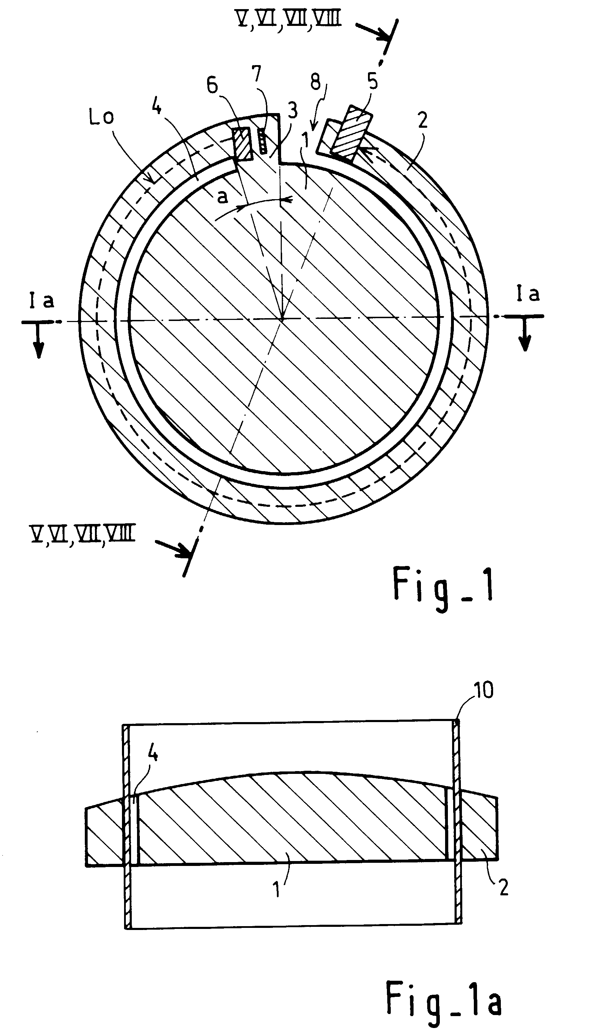

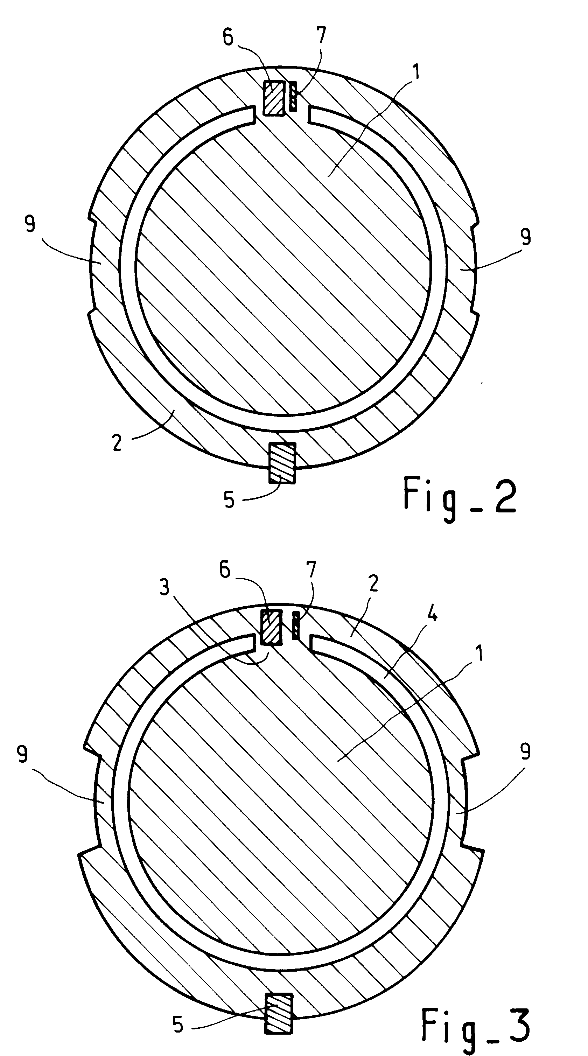

Les figures 1 et 2 sont des vues de dessus en coupe d'un résonateur selon deux modes de réalisation de l'invention.

Un résonateur se présente classiquement sous la forme d'un plaquette de quartz ou tout autre matériau piézo-électrique analogue, présentant en général un contour circulaire.

Selon l'invention, cette plaquette est évidée suivant un pourtour circulaire formant une lumière en forme de couronne sauf en un endroit particulier. On obtient ainsi un disque comportant une partie centrale 1 reliée à une partie périphérique en forme d'anneau 2 par un unique pont de liaison 3 disposé dans une zone intermédiaire 4 présentant une faible longueur dans le sens radial. l'évidement est réalisé de façon simple et connue par usinage ultrasonore par exemple et le pont de liaison est avantageusement réalisé sans former de discontinuité d'épaisseur avec les parties centrale 1 et périphérique 2. La largeur du pont unique de liaison 3 représente une faible fraction de la zone intermédiaire 4 qui n'excède pas en général cinq centièmes de la longueur de la courbe moyenne de la zone intermédiaire. La disposition de ce pont n'est pas indifférente, la qualité du résonateur étant particulièrement bonne si ce pont unique 3 est disposé selon une direction correspondant à un minimum ou un minimum absolu ou relatif du module d'Young pour le cristal.

La partie centrale 1 du cristal constitue sa partie active qui peut, soit être munie d'électrodes sur chacune de ses faces frontales, soit coopérer avec des électrodes indépendantes déposées sur des disques ou plateaux disposés en regard de chacune de ses faces frontales.

La partie périphérique 2 qui constitue une partie de support pour le résonateur, est fixée au boitier par une fixation 5 par exemple en forme de pince. Avantageusement, cette partie périphérique 2 peut être utilisée comme substrat de circuits électroniques tels que des oscillateurs ou des stabilisateurs par exemple.

Comme on le sait, le cristal piézo-électrique d'un résonateur destiné à servir de référence de fréquence doit être porté à sa température d'inversion et maintenu rigoureusement à cette température, qui est supérieure à la température ambiante, pour que le système présente une stabilité dans le temps qui soit la meilleure possible.

Cette mise en température et surtout le maintien à cette température sont réalisés selon l'invention essentiellement par chauffage interne de la partie active 1 du cristal du résonateur. Pour cela, un élément chauffant 6 est placé très près de la partie centrale vibrante 1 du résonateur, au niveau de la partie périphérique 2 prolongeant le pont unique de liaison 3. Un capteur de température 7 placé à côté de cet élément chauffant 6 et donc également au plus près de la partie vibrante 1, c'est-à-dire au niveau du pont de liaison 3, permet en outre une mesure de la température atteinte par le cristal.

Une boucle de régulation, non représentée, mais qui peut être réalisée par l'homme de l'art à partir de techniques classiques, assure une température constante au cristal en ajustant la puissance électrique de l'élément chauffant 6 en fonction de la température mesurée par le capteur ou sonde de température 7.

Dans un premier mode de réalisation, représenté figure 1, la partie périphérique 2 en forme d'anneau est ouverte sur une distance qui peut être de l'ordre de la largeur du pont unique de liaison 3, l'une des parois de l'ouverture 8 ainsi pratiquée étant disposée dans le prolongement de l'un des bords latéraux du pont de liaison 3, l'autre paroi délimitant une extrémité libre de l'anneau 2 ainsi interrompu. Il est ainsi créé un parcours thermique LO, entre l'élément chauffant 6 et la fixation 5 placée au niveau de cette extrémité libre, dont la longueur est sensiblement celle de la courbe moyenne de la partie périphérique 2 et qui présente une grande résistance thermique, lequel parcours canalise obligatoirement et de façon remarquable le flux thermique de conduction développé dans la partie vibrante du cristal 1. Cet éloignement le plus grand possible de la fixation 5 de l'élément chauffant 6, dû à la longueur de l'anneau 2, permet un contrôle amélioré de la température du résonateur alors que cet anneau assure lui même une bonne isolation thermique vis à vis de l'extérieur.

La pose d'un écran réflecteur au niveau par exemple des surfaces externes des disques ou plateaux recevant les électrodes indépendantes dans le cas d'un résonateur du type à électrodes non-adhérentes ou bien directement sur la partie périphérique 2 dans le cas d'un résonateur du type à électrodes adhérentes, comme le montre par exemple figure la, peut par ailleurs permettre de réduire ou même d'éliminer les échanges par rayonnement pouvant exister entre le résonateur et le boîtier dans lequel il est placé sous vide. Dans ce dernier cas, on peut observer que l'écran réflecteur ou miroir 10 est accolé à la face interne de la partie périphérique 2 en faisant face à la partie centrale 1.

L'évaluation du temps de stabilisation en fréquence est liée principalement à celle de la résistance thermique du résonateur à laquelle correspond une constante de temps propre qui peut être calculée et mesurée.

En particulier, la résistance thermique $R_R$ dépend de l'angle a (lié au diamètre d de la partie vibrante 1 du cristal et à la largeur L du pont par la relation $\frac{d}{2}\sin a = L$) selon la formule suivante:

$$R_R = \frac{1}{2\lambda e}\left[\pi - \frac{a}{2}\right](K/W)$$

où λ est la conductibilité du quartz dans la direction du pont et e l'épaisseur du quartz. En appliquant cette formule, on voit aisément que la résistance thermique par exemple d'un résonateur 10 MHz coupe SC partiel 3 peut varier de 630 K/W à 140 K/W et la constante de temps pour un tel résonateur est comprise entre 12 et 60s. La couronne 2 assure une bonne isolation thermique entre le pont 3 et la fixation 5 puisque sa résistance thermique est de l'ordre de 5 000 K/W, ceci sous-entend donc la mise en jeu d'une puissance de chauffage extrêmement faible.

Des essais ont montré que la stabilisation en fréquence pouvait être obtenue au bout de 3 minutes avec une puissance de l'ordre de 30mW avec un tel dispositif.

Dans un second mode de réalisation, représenté figure 2, afin de conserver une certaine symétrie au résonateur et donc garder une faible sensibilité accélérométrique, l'anneau 2 n'est pas interrompu et se trouve complet, mais la fixation 5 de l'anneau 2 est alors placée à l'opposé des éléments chauffant 6 et sonde thermique 7. Afin de conserver au parcours entre cet élément chauffant 6 et la fixation 5 une résistance thermique élevée, des restrictions thermiques 9 sont pratiquées symétriquement dans cet anneau 2, de part et d'autre de la partie centrale vibrante active 1 préférentiellement dans une direction perpendiculaire à la direction radiale définie par l'axe de symétrie du pont unique de liaison 3.

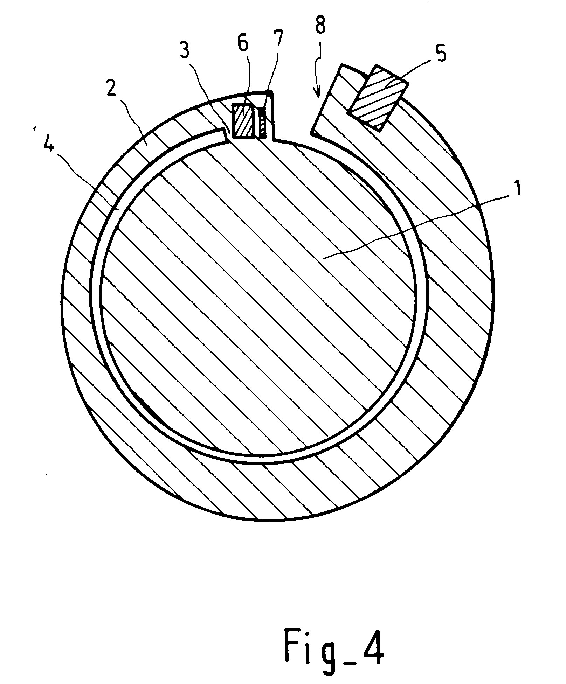

Il doit être noté que, comme représenté sur les figures 3 et 4, l'anneau 2 peut présenter une largeur non uniforme.

Ainsi, dans le mode de réalisation de la figure 3, qui est du type comportant un anneau 2 complet, celui-ci présente deux largeurs distinctes, la première correspondant à la partie de cet anneau comprise entre le pont de liaison 3 et les restrictions thermiques symétriques 9 et la seconde correspondant à l'autre partie comprise entre ces restrictions 9 et la fixation 5. Toutefois, la largeur de la partie intermédiaire 4 reste constante.

Dans le mode de réalisation de la figure 4, qui est du type à anneau 2 interrompu, celui-ci présente une largeur vibrant continûment d'une largeur minimale au niveau du pont de liaison 3 et donc de l'élément chauffant 6 et de la sonde 7 à une largeur maximale au niveau de son extrémité libre sur laquelle est fixée la fixation 5, la partie centrale 1 ayant un diamètre constant. La partie intermédiaire 4 présente elle-même également une largeur constante et faible dans le sens radial.

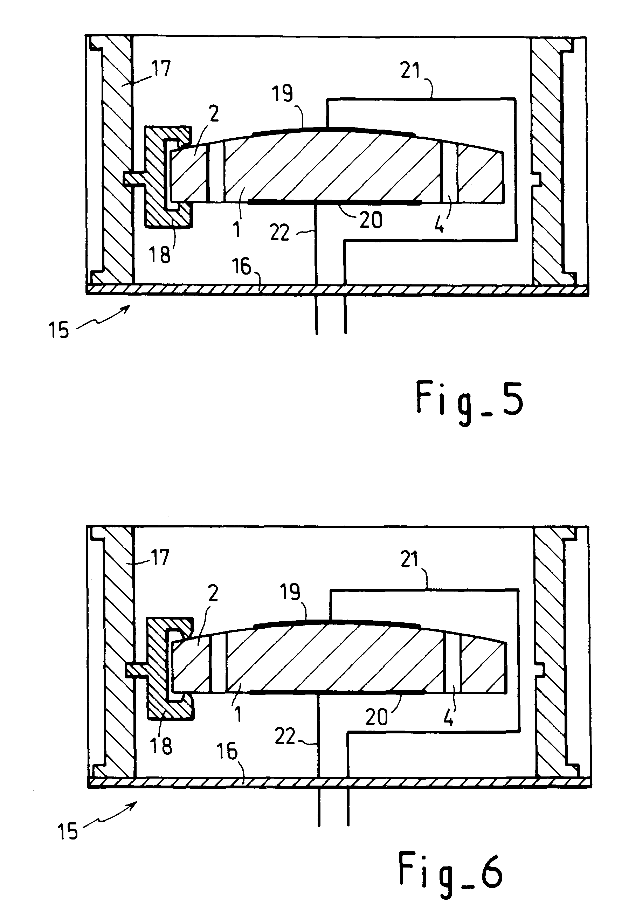

Les figures 5 à 8 montrent, dans une configuration à électrodes adhérentes et dans une configuration à électrodes non-adhérentes, le positionnement dans son boitier du résonateur selon l'invention.

Sur les figures 5 et 6, le boitier 15 comporte un support de base 16 sur lequel repose une paroi verticale 17, par exemple cylindrique, qui va recevoir la pince 18 maintenant le résonateur par sa partie périphérique 2. Les électrodes 19 et 20 adhérentes à la partie active du cristal 1 sont reliées par des fils de liaison 21 et 22 à des circuits électroniques, non représentés, de traitement des signaux, qui peuvent être situés à l'extérieur du boitier 15. Toutefois, la partie périphérique 2 du résonateur peut elle-même être utilisée comme substrat des circuits électroniques associés au résonateur.

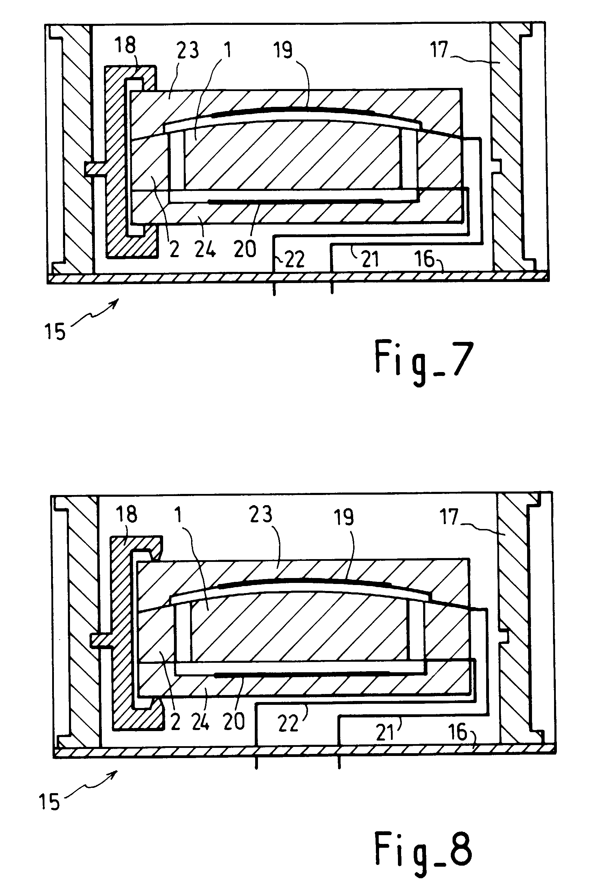

Au niveau des figures 7 et 8, qui présentent une configuration à électrodes non-adhérentes, ces électrodes 19 et 20 sont maintenues autour de la partie active du cristal 1 par une partie supérieure 23 et une partie inférieure 24 recouvrant le résonateur et prenant appui sur la partie périphérique 2. Comme dans la réalisation précédente, des fils de liaisons 21 et 22 permettent de relier ces électrodes à des circuits électroniques pouvant être situés à l'extérieur du boitier 15. Dans le cas des figures 7 et 8, la pince 18 maintenant le résonateur n'est plus directement en contact avec la partie périphérique 2 mais avec les faces externes des parties supérieure et inférieure 23,24, ce contact pouvant d'ailleurs être plan (figures 5 et 7) ou ponctuel (figures 6 et 8).

**Revendications**

1. Résonateur piézo-électrique à électrodes adhérentes ou non adhérentes au cristal, du type comprenant, montés dans un boîtier étanche, au moins un cristal piézo-électrique interposé entre des première et seconde électrodes reliées respectivement à des premier et second conducteurs se prolongeant hors du boîtier, et un moyen de fixation du cristal piézo-électrique à l'intérieur du boîtier, le cristal piézo-électrique comprenant une partie centrale (1) et une partie périphérique (2) formant un anneau entourant à distance la partie centrale et reliée à celle-ci par une partie intermédiaire (4), présentant une faible longueur dans le sens radial, et dans laquelle est pratiquée une lumière, caractérisé en ce que la partie périphérique (2) est reliée à la partie centrale (1) par un unique pont de liaison (3) constitué par la partie non évidée de cette partie intermédiaire (4), qui s'étend sur une faible fraction de la périphérie de cette partie intermédiaire (4),et en ce que la partie centrale (1) constitue la partie vibrante active du cristal tandis que la partie périphérique (2) est immobilisée dans le boîtier par le moyen de fixation (5) disposé de telle sorte qu'il soit thermiquement le plus éloigné possible de l'unique pont de liaison (3), ladite partie immobilisée et ledit pont constituant des moyens de suspension du cristal.

2. Résonateur selon la revendication 1, caractérisé en ce qu'il comprend un élément chauffant (6) placé au plus près de la partie centrale vibrante (1), au niveau de la partie périphérique (2) prolongeant l'unique pont de liaison (3), et un capteur de température (7) disposé à côté de cet élément chauffant (6), et en ce que des moyens sont prévus pour réguler la puissance électrique de l'élément chauffant (6) en fonction de la température mesurée par le capteur de température (7) afin d'assurer une température constante pour le cristal piézo-électrique.

3. Résonateur selon la revendication 1 ou la revendication 2, caractérisé en ce que la partie périphérique (2) formant anneau est interrompue créant une ouverture (8) dont l'une des parois est disposée dans le prolongement de l'un des bords latéraux du pont unique de liaison (3), l'autre paroi délimitant une extrémité libre à laquelle est fixé le moyen de fixation (5) de telle sorte que celui-ci soit thermiquement le plus éloigné possible du pont unique de liaison (3) recevant l'élément chauffant (6) et le capteur de température (7).

4. Résonateur selon la revendication 3, caractérisé en ce que la largeur de la partie périphérique (2) formant anneau varie continûment d'une largeur minimale au niveau du pont de liaison (3) à une largeur maximale au niveau de son extrémité libre où se trouve placé l'élément de fixation (5), la largeur de la partie intermédiaire (4) restant constante.

5. Résonateur selon la revendication 1 ou la revendication 2, caractérisé en ce que le moyen de fixation (5) du cristal au boîtier est placé au niveau d'une zone de la partie périphérique (2) située à l'opposé du pont unique de liaison (3) par rapport à la partie centrale active (1), et en ce que des restrictions thermiques (9) sont pratiquées symétriquement dans cette partie périphérique (2), de part et d'autre de la partie centrale (1), de telle sorte que le moyen de fixation (5) soit thermiquement le plus éloigné possible de l'élément chauffant (6) et du capteur de température (7).

6. Résonateur selon la revendication 5, caractérisé en ce que lesdites restrictions thermiques sont réalisées dans une direction perpendiculaire à la direction radiale définie par l'axe de symétrie du pont unique de liaison (3).

7. Résonateur selon la revendication 6, caractérisé en ce que la partie périphérique (2) formant anneau présente au moins deux largeurs distinctes, une première largeur pour une première partie de cet anneau comprise entre le pont unique de liaison (3) et les restrictions thermiques (9) et une seconde largeur pour une seconde partie comprise entre ces restrictions thermiques (9) et le moyen de fixation (5), la largeur de la partie intermédiaire (4) restant constante.

8. Résonateur selon l'une quelconque des revendications 1 à 7, caractérisé en ce que le pont unique de liaison (3), est disposé dans une direction qui correspond à un minimum ou un maximum absolu ou relatif du module d'Young pour le cristal.

9. Résonateur selon l'une quelconque des revendications 1 à 8, caractérisé en ce que la partie périphérique (2) est recouverte d'un écran réflecteur (10) placé sur sa face interne faisant face à la partie centrale (1), afin de diminuer le rayonnement émis par le cristal.

10. Résonateur selon l'une quelconque des revendications 1 à 9, caractérisé en ce qu'il est disposé dans une atmosphère dont la température est très inférieure à la température d'inversion du cristal piézo-électrique.

11. Résonateur selon l'une quelconque des revendications 1 à 10, caractérisé en ce que la partie périphérique (2) est utilisée comme substrat de circuits électroniques associés au résonateur tels que des circuits oscillateurs ou amplificateurs stabilisateurs.

12. Application du résonateur selon l'une quelconque des revendications 1 à 11 à un oscillateur thermostaté à faible consommation et chauffage rapide.

**Patentansprüche**

1. Piezoelektrischer Resonator, dessen Elektroden an dem Kristall haften oder nicht haften und der in einem dichten Gehäuse mindestens einen Piezoquarz aufweist, der zwischen einer ersten und einer zweiten Elektrode angeordnet ist, die mit einem ersten bzw. einem zweiten, aus dem Gehäuse herausführenden Leiter verbunden sind, sowie ein Mittel zur Befestigung des Piezoquarzes im Inneren des Gehäuses aufweist, wobei der Piezoquarz einen zentralen Teil (1) aufweist und einen Außenteil (2) aufweist, der einen Ring bildet, der den zentralen Bereich in einem Abstand umschließt und mit diesem durch einen Zwischenteil (4) verbunden ist, der in radialer Richtung eine geringe Länge aufweist und in dem eine Öffnung ausgeführt ist,
dadurch gekennzeichnet, daß der Außenteil (2) mit dem zentralen Teil (1) durch eine einzige Verbindungsbrücke (3) verbunden ist, die von dem nicht ausgesparten Teil dieses Zwischenteils (4) gebildet wird und sich über einen geringen Anteil der Außenlinie dieses Zwischenteils (4) erstreckt, und daß der zentrale Teil (1) den aktiven Schwingungsbereich des Quarzes bildet, während der Außenteil (2) im Gehäuse durch das Befestigungsmittel (5) festgehalten wird, das dergestalt angeordnet ist, daß es in thermischer Hinsicht so weit wie möglich von der einzigen Verbindungsbrücke (3) entfernt ist, wobei der genannte festgehaltene Teil und die genannte Brücke Aufhängungsmittel für den Quarz darstellen.

2. Resonator nach Anspruch 1,
dadurch gekennzeichnet, daß er ein Heizelement (6) umfaßt, das so nahe wie möglich an dem schwingenden zentralen Teil (1) im Bereich des Außenteils (2) angeordnet ist, der sich in der Verlängerung der einzigen Verbindungsbrücke (3) befindet, sowie einen Temperaturfühler (7) umfaßt, der neben diesem Heizelement (6) angeordnet ist, und daß Mittel vorgesehen sind, um den Stromverbrauch des Heizelements (6) in Abhängigkeit von der durch den Temperaturfühler (7) gemessenen Temperatur zu regulieren, so daß für den Piezoquarz eine konstante Temperatur gewährleistet ist.

3. Resonator nach Anspruch 1 oder Anspruch 2,
dadurch gekennzeichnet, daß der ringförmige Außenteil (2) durch eine Öffnung (8) unterbrochen wird, deren eine Wand sich in der Verlängerung einer der Seitenkanten der einzigen Verbindungsbrücke (3) befindet, wobei die andere Wand ein freies Ende umgrenzt, an dem das Befestigungsmittel (5) dergestalt angebracht ist, daß dieses in thermischer Hinsicht so weit wie möglich von der einzigen Verbindungsbrücke (3) entfernt ist, die das Heizelement (6) und den Temperaturfühler (7) aufnimmt.

4. Resonator nach Anspruch 3,
dadurch gekennzeichnet, daß die Breite des ringförmigen Außenteils (2) sich gleichmäßig von einer minimalen Breite im Bereich der Verbindungsbrücke (3) zu einer maximalen Breite im Bereich seines freien Endes verändert, wo das Befestigungsmittel (5) angebracht ist, wobei die Breite des Zwischenteils (4) konstant bleibt.

5. Resonator nach Anspruch 1 oder Anspruch 2,
dadurch gekennzeichnet, daß das Befestigungsmittel (5) des Kristalls an dem Gehäuse in Höhe eines Bereichs des Außenteils (2) angeordnet ist, der sich auf der von der einzigen Verbindungsbrücke (3) abgewandten Seite des aktiven zentralen Teils (1) befindet, und daß thermische Einengungen (9) in diesem Außenteil (2) zu beiden Seiten des zentralen Teils (1) symmetrisch wirken, so daß das Befestigungsmittel (5) in thermischer Hinsicht so weit wie möglich von dem Heizelement (6) und dem Temperaturfühler (7) entfernt ist.

**6.** Resonator nach Anspruch 5,
dadurch gekennzeichnet, daß die genannten thermischen Einengungen in einer Richtung ausgeführt sind, die senkrecht zu der radialen Richtung liegt, die durch die Symmetrieachse der einzigen Verbindungsbrücke (3) definiert wird.

**7.** Resonator nach Anspruch 6,
dadurch gekennzeichnet, daß das ringförmige Außenteil (2) mindestens zwei verschiedene Breiten aufweist, eine erste Breite in einem ersten Bereich dieses Rings zwischen der einzigen Verbindungsbrücke (3) und den thermischen Einengungen (9) und eine zweite Breite in einem zweiten Bereich zwischen diesen thermischen Einengungen (9) und dem Befestigungsmittel (5), wobei die Breite des Zwischenteils (4) konstant bleibt.

**8.** Resonator nach einem der Ansprüche 1 bis 7,
dadurch gekennzeichnet, daß die einzige Verbindungsbrücke (3) in einer Richtung angeordnet ist, die einem absoluten oder relativen Minimum oder Maximum des Elastizitätsmoduls des Kristalls entspricht.

**9.** Resonator nach einem der Ansprüche 1 bis 8,
dadurch gekennzeichnet, daß das Außenteil (2) von einem Reflektorschirm (10) abgedeckt ist, der an dessen dem zentralen Teil (1) gegenüberliegenden Innenseite angeordnet ist, um die von dem Kristall abgegebene Strahlung zu verringern.

**10.** Resonator nach einem der Ansprüche 1 bis 9,
dadurch gekennzeichnet, daß er in einer Atmosphäre angeordnet ist, deren Temperatur sehr viel geringer ist als die Umkehrtemperatur des Piezoquarzes.

**11.** Resonator nach einem der Ansprüche 1 bis 10,
dadurch gekennzeichnet, daß das Außenteil (2) als Substrat für elektronische Schaltungen verwendet wird, die mit dem Resonator verbunden werden, wie z. B. Oszillatorkreise oder Stabilisatorverstärker.

**12.** Verwendung des Resonators nach einem der Ansprüche 1 bis 11 für einen thermostabilisierten Oszillator mit niedrigem Energieverbrauch und kurzer Aufwärmzeit.

**Claims**

**1.** Piezoelectric resonator having a crystal with adherent or non-adherent electrodes, of the type comprising, mounted in a sealed box, at least one piezoelectric crystal interposed between first and second electrodes that are connected respectively to first and second conductors extending outside the box, and fastening means for fastening the piezoelectric crystal inside the box, the piezoelectric crystal comprising a central portion (1) and a peripheral portion (2) forming a ring that surrounds the central portion at a distance therefrom and that is connected thereto by an intermediate portion (4) that is narrow in the radial direction and in which a slot is formed, characterized in that the peripheral portion (2) is connected to the central portion (1) via a single connection bridge (3) constituted by the non-slotted portion of said intermediate portion (4) extending over a small fraction of the periphery of said intermediate portion (4) and in that the central portion (1) constitutes the active vibration portion of the crystal while the peripheral portion (2) is secured in the box by the fastening means (5) which is disposed in such a manner as to be thermally as remote as possible from the single connection bridge (3), said secured portion and said bridge constituting means for suspending the crystal.

**2.** Resonator according to claim 1, characterized in that it comprises a heater element (6) placed as close as possible to the vibrating central portion (1) in the peripheral portion (2) extending the single connection bridge (3), and a temperature sensor (7) disposed adjacent to said heater element (6), and in that means are provided for regulating the electrical power of the heater element (6) as a function of the temperature measured by the temperature sensor (7) in order to ensure a constant temperature for the piezoelectric crystal.

**3.** Resonator according to claim 1 or claim 2, characterized in that the ring-forming peripheral portion (2) is interrupted to form a gap (8) having one of its walls extending one of the lateral sides of the single connection bridge (3), the other wall defining a free end to which the fastening means (5) is fastened, such that said fastening means is thermally as remote as possible from the single connection bridge (3) that receives the heater element (6) and the temperature sensor (7).

4. Resonator according to claim 3, characterized in that the width of the ring-forming peripheral portion (2) varies continuously from a minimum width at the connection bridge (3) to a maximum width at its free end where the fastening element (5) is located, the width of the intermediate slot (4) remaining constant.

5. Resonator according to claim 1 or claim 2, characterized in that the fastening means (5) for fastening the crystal to the box is placed level with a region of the peripheral portion (2) situated opposite to the single connection bridge (3) relative to the active central portion (1), and in that thermal constrictions (9) are made symmetrically in the peripheral portion (2) on either side of the central portion (1), such that the fastening means (5) is thermally as remote as possible from the heater element (6) and the temperature sensor (7).

6. Resonator according to claim 5, characterized in that said thermal constrictions are made in a direction perpendicular to the radial direction defined by the axis of symmetry of the single connection bridge (3).

7. Resonator according to claim 6, characterized in that the ring-forming peripheral portion (2) has at least two different widths, a first width for a first portion of said ring extending between the single connection bridge (3) and the thermal constrictions (9) and a second width for a second portion extending between said thermal constrictions (9) and the fastening means (5), the width of the intermediate slot (4) remaining constant.

8. Resonator according to any one of claims 1 to 7, characterized in that the single connection bridge (3) is disposed in a direction that corresponds to an absolute or a relative minimum or maximum of Young's modulus for the crystal.

9. Resonator according to any one of claims 1 to 8, characterized in that the peripheral portion (2) is covered by a reflective screen (10) placed on its inside face facing the central portion (1) so as to reduce the radiation emitted by the crystal.

10. Resonator according to any one of claims 1 to 9, characterized in that the resonator is disposed in an atmosphere whose temperature is much less than the inversion temperature of the piezoelectric crystal.

11. Resonator according to any one of claims 1 to 10, characterized in that the peripheral portion (2) is used as a substrate for electronic circuits associated with the resonator, such as oscillator circuits or stabilizing amplifier circuits.

12. Use of the resonator according to any one of claims 1 to 11, as a thermostatically-controlled oscillator having low power consumption and rapid heating.

Fig_1

Fig_1a

9

EP 0 561 677 B1

Fig_2

Fig_3

10

Fig_4

Fig_5

Fig_6

Fig_7

Fig_8